Europäisches Patentamt

European Patent Office

Office européen des brevets

(11) Numéro de publication: **0 048 195**
**B1**

(19)

---

(12)

# FASCICULE DE BREVET EUROPEEN

(45) Date de publication du fascicule du brevet:
**25.04.84**

(51) Int. Cl.³: **H 01 P 5/18, H 01 Q 21/08**

(21) Numéro de dépôt: **81401375.1**

(22) Date de dépôt: **01.09.81**

---

(54) Coupleurs directifs en hyperfréquence entre guide d'onde rectangulaire et ligne triplaque.

---

(30) Priorité: **12.09.80 FR 8019693**

(43) Date de publication de la demande:
**24.03.82 Bulletin 82/12**

(45) Mention de la délivrance du brevet:
**25.04.84 Bulletin 84/17**

(84) Etats contractants désignés:
**DE GB NL**

(56) Documents cités:
**FR - A - 1 574 876**
**US - A - 3 587 004**
**US - A - 4 080 579**

(73) Titulaire: **SOCIETE D'ETUDE DU RADANT, Avenue de l'Atlantique Zone d'activités d'Orsay B.P. 39, F-91942 Les Ulis Cedex (FR)**

(72) Inventeur: **Saint, Jacques, 12, rue du Réveil Matin, F-78800 Houilles (FR)**
Inventeur: **Collignon, Gérard, C.E.S. Jean Mermoz 2, avenue Auzilleau, F-91600 Savigny sur Orge (FR)**

(74) Mandataire: **Lerner, François, 5, rue Jules Lefebvre, F-75009 Paris (FR)**

---

BUNDESDRUCKEREI BERLIN

Coupleurs directifs en hyperfréquence entre guide d'onde rectangulaire et ligne triplaque

La présente invention concerne un procédé permettant de coupler de façon directive une ligne de transmission de technologie triplaque ou microstrip à une ligne de transmission du type guide d'onde ainsi que l'application de ce procédé aux antennes plates hyperfréquence du type »dalle« et au contrôle de puissance hyperfréquence.

Bien que la tenue en puissance des lignes triplaque ait augmentée dans de grandes proportions grâce aux possibilités de collage des différents constituants, elle reste cependant relativement modeste.

Dans les antennes de forte puissance, il est donc parfois nécessaire d'utiliser un répartiteur de puissance principal réalisé en guide d'onde pouvant supporter des puissances élevées et alimentant le reste de l'antenne réalisée en technologie triplaque. La liaison entre les deux parties de l'antenne pouvant être plus ou moins performante.

Les différentes solutions de couplage guide-triplaque qui sont utilisées actuellement présentent de nombreuses limitations.

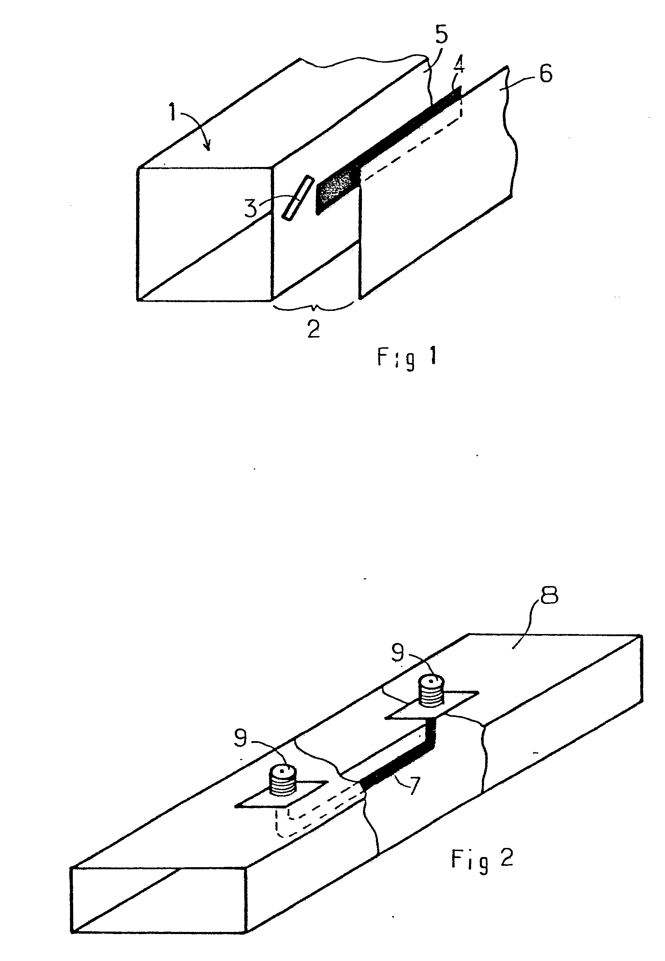

Nous rappelerons, en nous rapportant à la figure 1, la structure d'un coupleur classique guide-triplaque constitué d'une ligne triplaque 2 formée de deux plaques 5, 6 et d'un conducteur central 4 associée à plat sur l'un des côtés 5 d'un guide d'onde 1. Le couplage est assuré par une ou plusieurs fentes rayonnantes 3 couplées à l'âme conductrice du triplaque 4.

Ce mode de couplage, bien qu'efficace, ne permet pas d'obtenir de coefficients de couplage supérieurs à 0,1 soit 20 dB. Il faut citer également, en nous rapportant à la figure 2, le coupleur connu coaxial-guide constitué d'un bareau métallique 7 d'une longueur voisine de la demi-longueur d'onde plongeant dans le guide d'onde 8.

Ce type de coupleur permet d'atteindre des valeurs de coefficients de couplage importants, mais est relativement sélectif, la bande de fréquence de fonctionnement étant étroite. De plus, il nécessite un système de liaison 9 approprié avec une ligne triplaque éventuelle. Un tel coupleur est décrit au brevet FR-A-1 574 876. Le coefficient de couplage est réglé par l'enfoncement du conducteur à l'intérieur du guide d'onde. Cependant rien n'est prévu pour égaliser les vitesses de phase entre les deux modes de propagation couplés. En outre, on notera que la longueur du coupleur est voisine d'une demi-longueur d'onde.

Dans le brevet US-A-4 080 579 est décrit un coupleur directif hyperfréquence permettant le couplage d'une première ligne de transmission en guide d'onde (mode TE) et d'une deuxième ligne de transmission du type triplaque (mode TEM) utilisant une fente longitudinale formée dans le grand côté du guide d'onde et par laquelle est introduit dans le guide d'onde le conducteur de la deuxième ligne de transmission. Cependant dans ce dispositif aucun moyen n'est prévu pour égaliser les vitesses de phase des deux modes. Il en résulte des difficultés au niveau du couplage.

Le procédé objet de l'invention évite totalement les inconvénients rappelés ci-dessus et permet un excellent couplage entre un guide d'onde (mode TE) et une deuxième ligne de transmission du type triplaque (mode TEM).

Il permet des coefficients de couplage variant dans une grande gamme de valeurs de 6 dB à plus de 30 dB.

Il autorise une large bande de fréquence de fonctionnement, 15% autour de la fréquence nominale, sans modifications de caractéristiques.

Il ne nécessite pas d'élément intermédiaire, le coupleur utilisé fait partie intégrante de la ligne de transmission triplaque, les problèmes technologiques d'interconnexion sont supprimés.

Son encombrement est réduit du fait que sa longueur est voisine d'un quart de longueur d'onde.

A cet effet, conformément à l'invention, un coupleur directif hyperfréquence permettant le couplage d'une première ligne de transmission en guide d'onde (mode TE) et une deuxième ligne de transmission du type triplaque (mode TEM) utilisant une fente longitudinale formée dans le grand côté du guide d'onde et par laquelle est introduit dans le guide d'onde le conducteur de la deuxième ligne de transmission, se caractérise en ce que le conducteur central de la deuxième ligne de transmission est chargé à l'intérieur du guide de moyens d'accélération de phase. Ces moyens sont avantageusement soit des capacités montées en série, soit des selfs montées en parallèle sur le conducteur central.

Le coupleur objet de l'invention est avantageusement constitué d'une ligne triplaque dont le conducteur central est plongé dans le guide d'onde sur une longueur d'environ le quart de la longueur d'onde guidée.

L'invention se rapporte également à un procédé permettant de coupler une ligne de transmission en guide d'onde (mode TE) et une ligne de transmission en triplaque (mode TEM), connectées par un conducteur pénétrant dans le guide d'onde à travers une fente longitudinale ménagée dans un grand côté du guide d'onde, ce procédé se caractérisant en ce que la vitesse de propagation de l'onde dans la ligne triplaque est accélérée par l'intermédiaire de moyens déphaseurs tels que des capacités placées en série ou des selfs placées en parallèle sur ledit conducteur de façon à égaliser sensiblement les vitesses de phase dans les deux lignes de transmission entre les deux points de connexion de ces lignes.

L'invention et sa mise en œuvre apparaîtront plus clairement à l'aide de la description qui va suivre, faite en référence aux dessins annexés dans lesquels:

— les figures 1 et 2 montrent schématiquement deux types de coupleurs conformes à l'art antérieur,
— la figure 3 montre schématiquement et en vue perspective un coupleur réalisé selon l'invention,
— les figures 4 et 5 sont des schémas électriques relatifs à des modifications du coupleur illustré à la figure 3,
— la figure 6 montre schématiquement en vue perspective une application d'un coupleur conforme à l'invention,
— la figure 7 montre schématiquement en vue perspective une autre application.

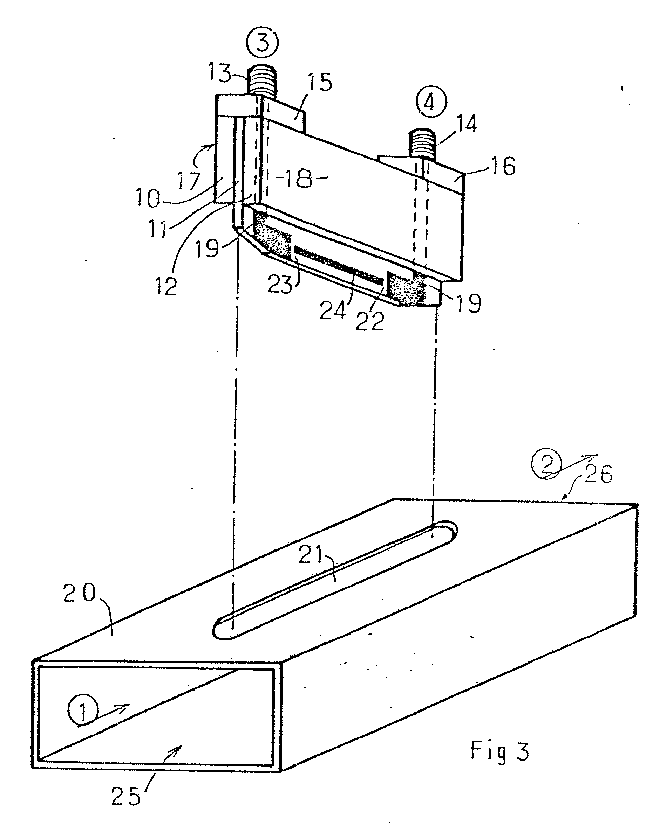

En se reportant à la figure 3, on décrira ci-dessous un exemple non limitatif de coupleur réalisé conformément à l'invention et fonctionnant dans la bande de 2700 à 3300 MHz. Il va de soi que ce type de coupleur est facilement transposable dans une autre bande de fréquence.

La ligne triplaque est un multicouche composé de trois lames diélectriques 10, 11, 12 de constante diélectrique $\varepsilon=2, 22$. Les accès 3, 4 (chiffres entourés) repérés 13, 14 de la ligne triplaque sont réalisés à l'aide de connecteurs coaxiaux miniatures 15, 16 de type SMA. Les deux lames diélectriques extérieures 10, 12 d'épaisseur 1,6 mm sont métallisées sur leur face externe par une feuille de cuivre de 35 microns d'épaisseur pour obtenir deux plans masses métallisés 17, 18.

La lame diélectrique intérieure 11 d'épaisseur 0,4 mm supporte le conducteur métallique central 19 de la ligne triplaque constitué d'un ruban de cuivre grâvé de largeur 2,7 mm qui donne à la ligne une impédance caractéristique de 50 Ohms. Cette lame intérieure se prolonge dans le guide d'onde 20 de type WR 284 et de dimensions 34 mm × 72 mm, à travers une fente 21 de longueur 38 mm et de largeur 4 mm.

A l'intérieur du guide d'onde, la largeur du conducteur central 19 passe à 8 mm afin de conserver une impédance caractéristique de 50 Ohms.

Afin de réaliser l'égalité des vitesses de phase, on constitue une cellule déphaseuse composée de deux capacités de 1 picofarad 22, 23 entre lesquelles est insérée une piste conductrice métallique 24 de largeur 1 mm, de longueur 20 mm, d'épaisseur 35 microns et d'impédance caractéristique 130 Ohms.

La longueur totale du coupleur est de 42 mm pour une longueur d'onde guidée de 140 mm.

Les caractéristiques électriques obtenues dans la bande de 2700 MHz à 3300 MHz sont les suivantes:

— coefficient de couplage 10 dB ± 0,3 dB,
— directivité supérieure à 15 dB,
— directivité supérieure à 20 dB dans la bande 2800 MHz—3200 MHz,

— taux d'ondes stationnaires (TOS) dans la voie triplaque inférieur à 1,4 )accès 3 et 4 — chiffres entourés),
— taux d'ondes stationnaires (TOS) dans la voie guide d'onde inférieur à 1,1 (accès 1 ou 2 — chiffres entourés — repérés en 25 et 26),
— tenue en puissance crête meilleure que 100 kW dans la voie guide d'onde (accès 1 ou 2 — chiffres entourés).

En chargeant périodiquement le conducteur central par des capacités en série ou des selfs en parallèle, (sur la figure 3 on a représenté un exemple avec deux capacités 22, 23) on a pu accélérer la vitesse de phase dans la ligne triplaque et la rendre égale à la vitesse de phase dans le guide. On a ainsi obtenu un bon couplage directif entre le guide d'onde (mode TE) et la ligne triplaque (mode TEM). La longueur électrique du coupleur vue par l'entrée 3 (chiffre entouré) de la ligne triplaque est égale au quart de la longueur d'onde guidée. On a donc ramené le problème au couplage entre deux lignes identiques.

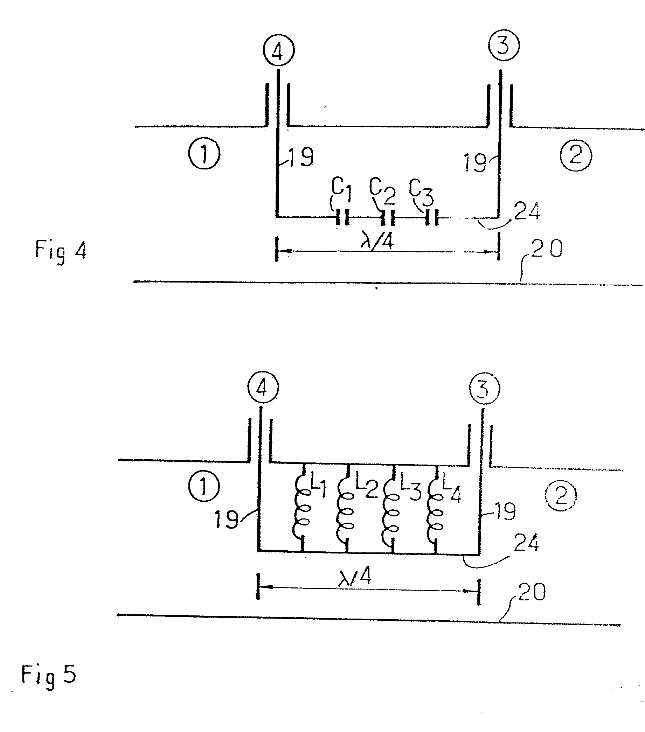

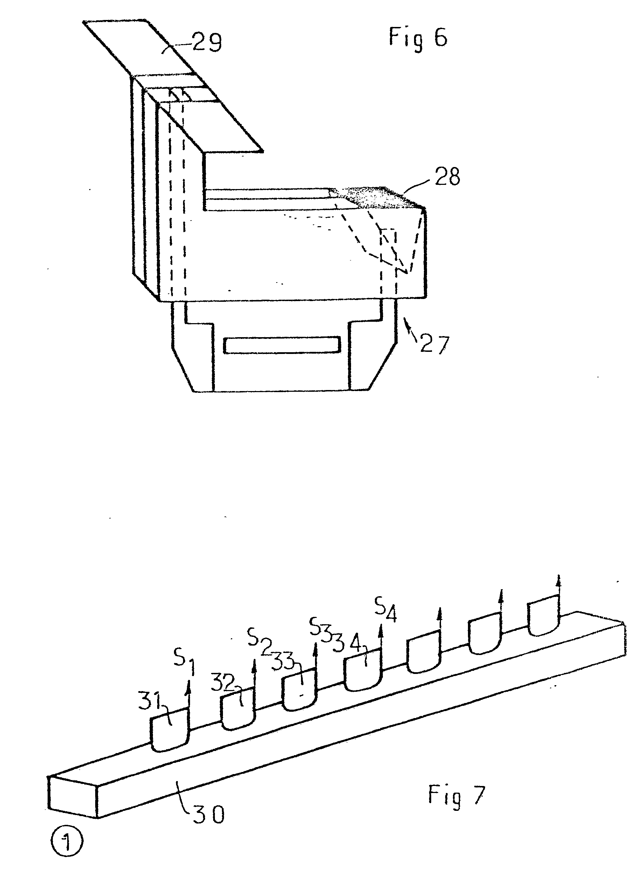

On se reportera maintenant aux figures 4 et 5 qui représentent schématiquement deux coupleurs réalisés respectivement selon le même principe que celui de la figure 3 avec trois capacités C1, C2, C3 montées en série sur le conducteur 24 ou quatre selfs L1, L2, L3, L4 montées en parallèle entre le conducteur 24 et la paroi adjacente du guide 20. Bien entendu, le nombre des capacités ou self utilisé n'est pas limitatif. Les accès 1 et 2 (chiffres entourés) étant les entrées et sorties du guide d'onde (mode TE), les accès 3 et 4 (chiffres entourés) étant les sorties de la ligne triplaque (mode TEM).

Différentes valeurs de couplage sont obtenues en modifiant la largeur et l'enfoncement de la piste conductrice 24. L'adaptation et la directivité optimales sont réalisées par les capacités ou les selfs.

Avec une ligne chargée par seulement deux capacités 22, 23, comme illustré à la figure 3, on obtient une directivité supérieure à 20 dB dans une bande de fréquence de 13%, soit 2800 MHz à 3200 MHz. Les coefficients de couplage peuvent varier selon la largeur de la piste 24 de 6 dB à 30 dB. Cette solution présente donc l'avantage d'obtenir des coupleurs peu encombrants à large bande de fréquence et supprime tout problème d'interconnexion.

De plus, en agissant sur la valeur des capacités, il est possible de diminuer encore la longueur du coupleur mais au détriment de la bande de fréquence.

On se reportera maintenant à la figure 6 qui montre une application importante du procédé de couplage suivant l'invention à la réalisation de modules rayonnants par association d'un coupleur 27 du type décrit ci-dessus (figure 3), d'une charge adaptée 28 et d'un dipôle rayonnant 29. Le coupleur fait partie intégrante de la ligne de transmission triplaque. Il n'y a pas de pièces annexes de connexion à l'élément rayonnant réalisé lui aussi en triplaque. Ce coupleur peut également être utilisé pour le contrôle de puissance sur des installation comportant des guides d'onde, en pratiquant une petite fente longitudinale au milieu du grand côté du guide (fente non perturbatrice et non rayonnante).

Pour ce faire, il suffit de plonger le conducteur central du coupleur, suivant l'invention, dans le guide d'onde à contrôler par une fente longitudinale non perturbatrice et non rayonnante car pratiquée au milieu du grand côté du guide et de le connecter à un milliwattmètre.

A la figure 7, on a illustré une autre application à la réalisation de répartiteurs de puissance d'antennes plates dont les éléments rayonnants sont réalisés en technologie triplaque. Le répartiteur est composé d'un guide d'onde 30 sur lequel sont associés en série plusieurs coupleurs 31, 32, 33, . . .; l'entrée (chiffre entouré) du répartiteur peut supporter des puissantes élevées, les sorties S1, S2, . . . sont indépendantes et découplées entre elles.

La possibilité de préciser le coefficient de couplage de chaque coupleur dans une plage de 6 à 30 dB permet d'obtenir à la demande toute loi de répartition d'énergie rayonnée.

**Revendications**

1. Coupleur directif hyperfréquence permettant le couplage d'une première ligne de transmission en guide d'onde (mode TE) (20) et d'une deuxième ligne de transmission du type triplaque (10, 11, 12) (mode TEM) utilisant une fente longitudinale (21) formée dans le grand côté du guide d'onde et par laquelle est introduit, dans le guide d'onde, le conducteur de la deuxième ligne de transmission, ledit coupleur étant caractérisé en ce que le conducteur central (24) de la deuxième ligne de transmission est chargé à l'intérieur du guide (20) de moyens (22, 23) d'accélération de phase.

2. Coupleur selon la revendication 1, caractérisé en ce que lesdits moyens d'accélération de phase sont des capacités (C₁, C₂, C₃) montées en série sur ledit conducteur central (24).

3. Coupleur selon la revendication 1, caractérisé en ce que lesdits moyens d'accélération de phase sont des selfs (L₁, L₂, L₃, L₄) montées en parallèle sur ledit conducteur central (24).

4. Coupleur selon l'une des revendications précédentes caractérisé en ce que la distance séparant les deux prises (13, 14) ou longueur du conducteur central de la deuxième ligne de transmission plongeant dans le guide d'onde (20) est sensiblement égale au quart de la longeur d'onde en mode guidé de ladite onde dans ledit guide.

5. Coupleur selon l'une des revendications précédentes, caractérisé en ce que la section des conducteurs centraux (19) d'accès dans le guide d'onde (20) est élargie à leur base plongeant dans le guide d'onde.

6. Coupleur selon l'une des revendications précédentes, caractérisé en ce que la ligne triplaque comporte une plaque centrale diélectrique (11) supportant le conducteur central (24) plongé dans le guide d'onde (20) et deux conducteurs d'accès (19) se terminant le chaque côté du conducteur central (24) par des parties élargies et deux plaques diélectriques (10, 12) entourant ladite plaque centrale (11) métallisées sur leurs faces extérieures (17, 18) et s'arrêtant au niveau de la face extérieure du guide d'onde (20) dans lequel est ménagée la fente (21) permettant le couplage.

7. Utilisation de coupleurs selon l'une des revendications précédentes pour former un dispositif répartiteur de puissance caractérisé en ce qu'il comprend plusieurs coupleurs précités (31, 32, 33, . . .) montés en série sur un même guide d'onde (20) (fig. 7).

8. Utilisation de coupleurs selon l'une des revendications 1 à 6 pour former un dispositif formant module rayonnant caractérisé en ce qu'il comprend un coupleur précité (27) monté sur un guide d'onde, ledit coupleur ayant une de ses sorties reliée à une charge adaptée (28) et son autre sortie à un dipole rayonnant (29) (fig. 6).

9. Procédé permettant de coupler une ligne de transmission en guide d'onde (mode TE) et une ligne de transmission en triplaque (mode TEM) connectées par un conducteur pénétrant dans le guide d'onde à travers une fente longitudinale ménagée dans un grand côté du guide d'onde, caractérisé en ce que la vitesse de propagation de l'onde dans la ligne triplaque est accélérée par l'intermédiaire de moyens déphaseurs (22, 23) tels que des capacités placées en série ou des selfs placées en parallèle sur ledit conducteur (24) de façon à égaliser sensiblement les vitesses de phase dans les deux lignes de transmission entre les deux points de connexion de ces lignes.

**Patentansprüche**

1. Mikrowellenrichtungskoppler zum Verkoppeln einer ersten Hohlleiterübertragungsleitung (vom Typ TE) (20) mit einer zweiten Übertragungsleitung vom Streifentyp (10, 11, 12) (vom Typ TEM) unter Verwendung eines Längsschlitzes (21), der in der großen Seite des Hohlleiters gebildet ist und durch welchen der Leiter der zweiten Übertragungsleitung in den Hohlleiter eingeführt wird, dadurch gekennzeichnet, daß der zentrale Leiter (24) der zweiten Übertragungsleitung im Inneren des Leiters (20) mit Phasenbeschleunigungsmitteln (22, 23) ausgestattet ist.

2. Richtungskoppler nach Anspruch 1, dadurch gekennzeichnet, daß die Phasenbeschleunigungsmittel Kondensatoren (C₁, C₂, C₃) sind, die in Reihe auf diesem zentralen Leiter (24) montiert sind.

3. Richtungskoppler nach Anspruch 1, dadurch gekennzeichnet, daß die Phasenbeschleunigungsmittel Induktionsspulen (L₁, L₂, L₃, L₄) sind, die parallel auf diesem zentralen Leiter (24) angebracht sind.

4. Richtungskoppler nach einem der vorhergehenden Ansprüche, dadurch gekennzeichnet, daß der die zwei Anschlüsse (13, 14) trennende Abstand oder die Länge des zentralen Leiters der zweiten, in den Hohlleiter (20) eintauchenden Übertragungsleitung etwa gleich einem Viertel der Länge der in diesen Hohlleiter geleiteten Welle ist.

5. Richtungskoppler nach einem der vorhergehenden Ansprüche, dadurch gekennzeichnet, daß der Abschnitt der zentralen Leiter (19) für den Zugang in den Hohlleiter (20) an ihrer in den Hohlleiter eintauchenden Basis verbreitert ist.

6. Richtungskoppler nach einem der vorhergehenden Ansprüche, dadurch gekennzeichnet, daß die Streifenleitung eine dielektrische zentrale Platte (11), welche den zentralen Leiter (24) haltert, welcher in dem Hohlleiter (20) eingetaucht ist, und zwei Zugangsleiter (19), die auf jeder Seite des zentralen Leiters (24) mit verbreiterten Teilen münden, und zwei dielektrische Platten (10, 12) aufweist, welche die zentrale Platte (11) umgeben, die auf ihren Außenflächen (17, 18) metallisiert sind und auf der Höhe der Außenfläche des Hohlleiters (20) befestigt sind, in welchem der Schlitz (21) für die Koppelung angeordnet ist.

7. Verwendung der Koppler nach einem der vorhergehenden Ansprüche zur Bildung einer Vorrichtung zum Verteilen der Energie, dadurch gekennzeichnet, daß sie mehrere vorgenannte Koppler (31, 32, 33, . . .) aufweist, die in Reihe auf demselben Hohlleiter (30) angebracht sind (Fig. 7).

8. Verwendung der Koppler nach einem der Ansprüche 1 bis 6 zur Bildung einer Vorrichtung für ein Strahlungsmodul, dadurch gekennzeichnet, daß sie einen vorgenannten Koppler (27) aufweist, der auf einem Hohlleiter angebracht ist, und daß einer der Ausgänge dieses Kopplers mit einer angepaßten Last (28) und sein anderer Ausgang mit einem strahlenden Dipol (29) verbunden ist (Fig. 6).

9. Verfahren zum Verkoppeln einer Hohlleiterübertragungsleitung (vom Typ TE) und einer Übertragungsstreifenleitung (vom Typ TEM), die durch einen Leiter verbunden sind, welcher durch einen Längsschlitz in den Hohlleiter eintritt, wobei der Schlitz in der großen Seite des Hohlleiters angebracht ist, dadurch gekennzeichnet, daß die Ausbreitungsgeschwindigkeit der Welle in der Streifenleitung mit Hilfe von Phasenverschiebungsmitteln (22, 23) beschleunigt wird, wie in Reihe angeordnete Kondensatoren oder parallel am Leiter (24) angeordnete Induktionsspulen zum ungefähren Ausgleichen der Phasengeschwindigkeiten in den zwei Übertragungsleitungen zwischen den zwei Verbindungspunkten dieser Leitungen.

**Claims**

1. Hyperfrequency directional coupler for coupling a first wave guide transmission line (mode TE) (20) and a second transmission line of the triplate type (10, 11, 12) (mode TEM) using a longitudinal slot (21) formed in the large side of the wave guide and through which is introduced, into the wave guide, the conductor of the second transmission line, the said coupler being characterised in that the central conductor (24) of the second transmission line is charged inside the guide (20) with phase acceleration means (22, 23).

2. Coupler according to Claim 1, characterised in that the said phase acceleration means are capacitors ($C_1$, $C_2$, $C_3$) mounted in series on the said central conductor (24).

3. Coupler according to Claim 1, characterised in that the said phase acceleration means are induction coils ($L_1$, $L_2$, $L_3$, $L_4$) mounted in parallel on the said central conductor (24).

4. Coupler according to one of the preceding Claims, characterised in that the distance separating the two connections (13, 14) or the length of the central conductor of the second transmission line plunging into the wave guide (20) is substantially equal to a quarter of the guided mode wave length of the said wave in the said guide.

5. Coupler according to one of the preceding Claims, characterised in that the section of the central conductors (19) for access into the wave guide (20) is increased in width at their base plunging into the wave guide.

6. Coupler according to one of the preceding Claims, characterised in that the triplate line comprises a central dielectric plate (11) supporting the central conductor (24) which plunges into the wave guide (20) and two access conductors (19) ending on each side of the central conductor (24) in parts of increased width and two dielectric plates (10, 12) surrounding the said central plate (11), metallised on their external surfaces (17, 18) and stopping at the level of the external surface of the wave guide (20) in which is formed the slot (21) enabling coupling to take place.

7. Use of couplers according to one of the preceding Claims to form a power distributing 7. Use of couplers according to one of the preceding Claims to form a power distributing device, characterised in that it comprises several aforesaid couplers (31, 32, 33, ., . .) mounted in series on a same wave guide (30) (fig. 7).

8. Use of couplers according to one of the Claims 1 to 6 to form a device forming a radiant module, characterised in that it comprises an aforesaid coupler (27) mounted on a wave guide, the said coupler having one of its outlets connected to an adapted charge (28) and its other outlet to a radiant dipole (29) (fig. 6).

9. Process for coupling a wave guide transmission line (mode TE) and a triplate transmission line (mode TEM) connected by a conductor penetrating the wave guide through a longitudinal slot formed in a large side of the wave guide, characterised in that the speed of propagation of the wave in the triplate line is accelerated by the intermediary of dephaser means (22, 23) such as capacitors placed in series or induction coils placed in parallel on the said conductor (24) so as substantially to equalize the phase velocities in the two transmission lines between the two points of connection of these lines.

Fig 1

Fig 2

Fig 3

Fig 4

Fig 5

Fig 6

Fig 7